# EUROPEAN PATENT APPLICATION

(11) **EP 4 586 752 A1**
(43) Date of publication of application: **16.07.2025**
(21) Application number: 23863546.0
(22) Date of filing: 08.09.2023
(51) Int. Cl.: H05K 7/20

(54) **HEAT DISSIPATION APPARATUS FOR ELECTRONIC DEVICE**

(30) Priority: 08.09.2022 KR 20220114426; 07.09.2023 KR 20230118872
(71) Applicant: KMW Inc., Hwaseong-si, Gyeonggi-do 18462 (KR)
(72) Inventor: KIM, Duk Yong, Yongin-si Gyeonggi-do 17086 (KR); LEE, Kang Hyun, Hwaseong-si Gyeonggi-do 18442 (KR); KIM, Jong Nam, Hwaseong-si Gyeonggi-do 18420 (KR)
(74) Representative: Impuls legal PartG mbB
(86) International application number: PCT/KR2023/013472
(87) International publication number: WO 2024/054082

(57) **Abstract**

The present invention relates to a heat dissipation apparatus for an electronic device. In particular, the heat dissipation apparatus comprises: a heat conduction panel body having formed therein a refrigerant flow space in which, while charged refrigerant changes in phase, gas-liquid circulation takes place; and an absorber which is disposed in the refrigerant flow space of the heat conduction panel body, and which distributes, while absorbing and holding the liquefied refrigerant of the refrigerant, the liquefied refrigerant in the direction of gravity or at least in a direction opposite to the direction of gravity, wherein, due to the material itself, the absorber prevents shape deformation in the direction of gravity even while maintaining the absorption rate for the liquefied refrigerant, and thus, provided is the advantage of greatly improving overall heat dissipation performance.

## Description

### [Technical Field]

The present disclosure relates to a heat dissipation apparatus for an electronic device, and more particularly, to a heat dissipation apparatus for an electronic device, which can improve heat dissipation performance by preventing a change in a shape thereof attributable to gravity while maintaining absorption power of a refrigerant in a liquid state (liquefied refrigerant).

### [Background Art]

In various industry fields, such as communication, electron, and electricity, related technologies tend to be continuously developed in a high level for application to a more advanced industry. In order to develop a high level technology, high output energy is required. A device that uses high output energy necessarily faces a high heating problem. Accordingly, the development of a cooling system having an adequate level needs to be accompanied.

The cooling system is used in various industries, such as an air conditioner, mobile communication, a data center, aerial mobility, electric vehicles, and energy storage devices, and displays. Such a cooling system is one of major causes of power consumption. Power consumption tends to be gradually increased as the industry is developed.

In general, a cooling device is basically divided into an active cooling device and a passive cooling device. The active cooling device basically uses forced convection by a fan. The passive cooling device may be classified as a technology using natural convection not using a fan.

In this case, a conventional cooling system has limitations in discharging high heat that is generated according to an advancement technology that is continuously developed. Industry fields related thereto require an innovative technology capable of solving such a problem. As a part of solving the innovative technology, a heat dissipation apparatus using a phase change material is being developed.

In this case, it is preferred that the heat dissipation apparatus using the phase change material is designed to have a structure so that the state of a liquefied refrigerant is changed into the state of a gaseous refrigerant at a portion closest to heating elements, that is, a target for heat dissipation. However, if the heating elements are provided to be spaced apart from each other in the direction of gravity, the most important factor is to properly distribute the liquefied refrigerant at each position of each heating element in order to improve heat dissipation performance in that the liquefied refrigerant is downward biased and stored due to gravity.

Conventionally, a heat dissipation apparatus, such as a vapor chamber adopts a technical construction in which a wick member in which multiple pores have been formed is integrated with a space (refrigerant flow space) in which a liquefied refrigerant and a gaseous refrigerant are circulated by a sintering method and the liquefied refrigerant is distributed by using surface tension properties of liquids, as a structure for distributing the liquefied refrigerant.

However, there are limitations in distributing the liquefied refrigerant in the direction of gravity by defying gravity by using surface tension properties of liquids. Furthermore, there are problems in that a method of manufacturing and installing the wick member is very complicated and the productivity of products is reduced.

Furthermore, in general, a heat dissipation apparatus, such as a vapor chamber, has a structure that is horizontally disposed at the top of heating elements that are flatly provided and that transfers or discharges heat, due to the limited distribution of a liquefied refrigerant using the surface tension of liquids, and has a problem in that the usage of the heat dissipation apparatus is very limited.

### [DISCLOSURE]

### [Technical Problem]

The present disclosure has been contrived to solve the technical problems, and an object of the present disclosure is to provide a heat dissipation apparatus for an electronic device, including an absorber which can form a dispersion force greater than surface tension of liquids in a direction opposite to the direction of gravity based on the liquid absorption rate of a material itself and can maintain its shape even in the state in which the absorber has absorbed a liquefied refrigerant.

Furthermore, another object of the present disclosure is to provide a heat dissipation apparatus for an electronic device, which can be generally applied regardless of the arrangement and design of heating elements.

Objects of the present disclosure are not limited to the aforementioned objects, and the other objects not described above may be evidently understood from the following description by those skilled in the art.

### [Technical Solution]

A heat dissipation apparatus for an electronic device according to an embodiment of the present disclosure includes a heat conduction panel body in which a refrigerant flow space where a liquefied refrigerant and a gaseous refrigerant are circulated while a state of a refrigerant filled therein is changed has been formed and an absorber disposed in the refrigerant flow space of the heat conduction panel body and configured to distribute a liquefied refrigerant included in the refrigerant in a direction of gravity or at least in a direction opposite to the direction of gravity while absorbing and retaining the liquefied refrigerant. The absorber maintains an absorption rate for the liquefied refrigerant by a material itself, and a shape of the absorber is prevented from being deformed in the direction of gravity.

In this case, the absorber may include an absorption body part having an absorption rate for the liquefied refrigerant and having a shape deformed by an external force having predetermined gravity or more and a frame retention part combined with the absorption body part and configured to prevent the shape of the absorption body part from being deformed by the external force.

Furthermore, the absorption body part may be made of at least one of non-woven fabric, cotton, and sponge.

Furthermore, the frame retention part may be formed in a tube shape in which the frame retention part forms a hollow having the absorption body part disposed therein as a metal material.

Furthermore, the frame retention part may have a metal wire braided in the tube shape.

Furthermore, the frame retention part may be braided to have a gap through which at least a liquefied refrigerant included in the refrigerant is transferred from an outside to the internal absorption body part by surface tension of the liquefied refrigerant.

Furthermore, a material having predetermined thermal conductivity or more may be adopted as the metal material of the frame retention part.

Furthermore, the metal material of the frame retention part may include copper.

Furthermore, the frame retention part may be formed in a cylindrical shape. The absorption body part may be formed in a cylindrical shape so that the absorption body part is inserted into the frame retention part formed in the cylindrical shape.

Furthermore, the heat conduction panel body may be formed of a metal panel member having predetermined thermal conductivity or more, and may include one-side heat conduction panel that forms one side of the refrigerant flow space and the other-side heat conduction panel that forms the other side of the refrigerant flow space. The absorber may be installed close to an end that belongs to the refrigerant flow space between the one-side heat conduction panel and the other-side heat conduction panel and that is adjacent to an external heating element on one side thereof.

Furthermore, the refrigerant flow space may include a first refrigerant flow path that forms the end on the one side at which the absorber is installed and a second refrigerant flow path slantly formed in the direction of gravity with respect to the first refrigerant flow path and defined by slant guides formed in the one-side heat conduction panel and the other-side heat conduction panel so that a thickness of the refrigerant flow space is reduced. The absorber may be installed in the first refrigerant flow path.

Furthermore, when the first refrigerant flow path in which the absorber is installed is installed to receive heat of the heating element, at least one end and the other end of the absorber may be disposed to be spaced apart from each other at a predetermined interval in the direction of gravity.

### [Advantageous Effects]

The heat dissipation apparatus for an electronic device according to an embodiment of the present disclosure may achieve the following various effects.

First, heat dissipation performance can be greatly improved by increasing a gas-liquid circulation ratio because it is possible to overcome the limited distribution of a liquefied refrigerant in a direction opposite to the direction of gravity through unique surface tension of liquids and to uniformly distribute a liquefied refrigerant in the direction of gravity.

Second, the variety of a coupling design for heating elements can be increased because the arrangement and design of the heating elements are not limited.

### [Description of Drawings]

FIG. 1 is a perspective view illustrating a rear part of an antenna apparatus in which a heat dissipation apparatus for an electronic device according to an embodiment of the present disclosure has been installed.
FIG. 2 is an exploded perspective view illustrating the rear part of the antenna apparatus of FIG. 1.
FIG. 3 is a perspective view illustrating the heat dissipation apparatus for an electronic device according to an embodiment of the present disclosure.
FIG. 4 is an exploded perspective view of FIG. 3.
FIG. 5 is an incision perspective view (a) of FIG. 3, a partially enlarged view (b) thereof, and a cross-sectional view (c) of a corresponding portion.
FIGS. 6 and 7 are perspective views illustrating various embodiments of an absorber, among the components of FIG. 5.

### <Description of reference numerals>

100: antenna apparatus 110: heat dissipation housing main body
150: press-fit part 200: heat dissipation apparatus
200P: heat conduction panel body 200-1: one-side heat conduction panel
200-2: other-side heat conduction panel 205: refrigerant flow space
210: first refrigerant flow path 215; multiple slant guides
220: second refrigerant flow path 240: multiple strength reinforcement parts
300: absorber 310: absorption body part
320,321,322: frame retention part

### [Best Mode]

Hereinafter, a heat dissipation apparatus for an electronic device according to an embodiment of the present disclosure is described in detail with reference to the accompanying drawings.

In adding reference numerals to the components of each drawing, it should be noted that the same components have the same reference numerals as much as possible even if they are displayed in different drawings. Furthermore, in describing embodiments of the present disclosure, when it is determined that a detailed description of the related well-known configuration or function hinders understanding of an embodiment of the present disclosure, the detailed description thereof will be omitted.

In describing components of an embodiment of the present disclosure, terms, such as a first, a second, A, B, (a), and (b), may be used. Such terms are used only to distinguish one component from another component, and the essence, order, or sequence of a corresponding component is not limited by the terms. All terms used herein, including technical or scientific terms, have the same meanings as those commonly understood by a person having ordinary knowledge in the art to which the present disclosure pertains, unless defined otherwise in the specification. Terms, such as those commonly used and defined in dictionaries, should be construed as having the same meanings as those in the context of a related technology, and are not construed as having ideal or excessively formal meanings unless explicitly defined otherwise in the specification.

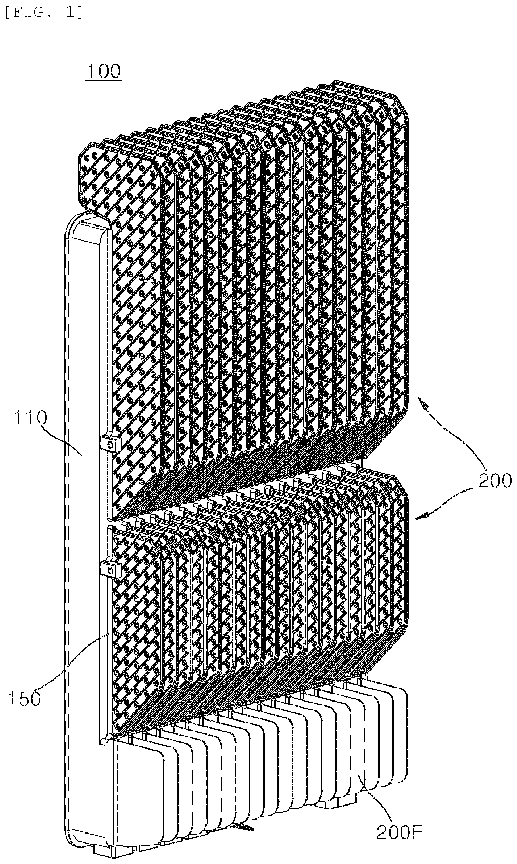

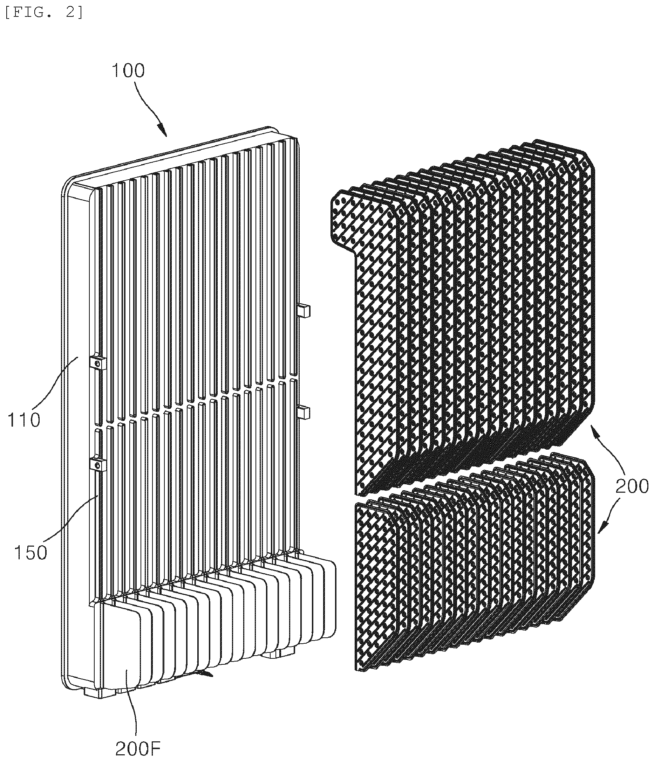

FIG. 1 is a perspective view illustrating a rear part of an antenna apparatus in which a heat dissipation apparatus for an electronic device according to an embodiment of the present disclosure has been installed. FIG. 2 is an exploded perspective view illustrating the rear part of the antenna apparatus of FIG. 1.

In general, an electronic device is manufactured in various forms over the entire industry, but the applicant of the present disclosure is a company engaged in the manufacturing of other wireless communication devices. A detailed example of an antenna apparatus is described as a representative electronic device. A digital element, such as an FPGA that is one of representative heating elements, and prepared analog elements, such as a PA that functions to amplify a signal and an LNA, are installed within the antenna apparatus. Performance of the apparatus may depend on the effective discharge of heat that is generated from the digital element and the analog elements.

However, heat dissipation equipment described later according to embodiments of the present disclosure should not be essentially limited and interpreted with respect to an antenna apparatus.

As reference in FIGS. 1 and 2, an antenna apparatus 100 to which a heat dissipation apparatus 200 for an electronic device according to an embodiment of the present disclosure has been applied includes a heat dissipation housing main body 110 that forms an accommodation space opened forward and that is formed in a rectangular parallelepiped shape in which the heat dissipation housing main body has a front and rear accommodation width that is long and thin approximately up and down.

Although not illustrated in the drawings, a main board having multiple micro bellows filter (MBF) elements mounted on a front surface thereof and heating elements mounted on a rear surface thereof through the medium of a clamshell as a substrate for a power amplifier unit (PAU) and a digital transceiving unit (DTU) may be stacked disposed within the accommodation space of the heat dissipation housing main body 110.

In this case, heating elements, which generate a significant amount of heat during the operation of FPGA elements, RFIC elements, PA elements, or LNA elements may be mounted on the rear surface of the main board.

However, in an embodiment of the present disclosure, an electronic device is merely described as being adopted as the antenna apparatus. It is to be noted that the heating elements are not limited to the construction. For example, the heating elements may be adopted as a semiconductor, that is, a representative heating element.

A radome panel (a reference numeral not assigned) is installed on a front surface of the accommodation space of the heat dissipation housing main body 110, and may function to protect radiation elements implemented with antenna elements and also to smoothly radiate heat from the radiation elements.

Meanwhile, the heat dissipation apparatus 200 according to an embodiment of the present disclosure may be installed on a rear surface of the heat dissipation housing main body 110.

The heat dissipation apparatus 200 for an electronic device according to an embodiment of the present disclosure is provided as a kind of heat dissipation pin form, and may be provided in a plate type heat exchanger (PTX) type having a thin thickness, which essentially includes therein an absorber 300 that absorbs liquefied refrigerant included in a refrigerant, strictly unlike a fixed heat dissipation pin 200F described later.

As reference in FIGS. 1 and 2, the heat dissipation apparatus 200 according to an embodiment of the present disclosure is lengthways disposed up and down vertically on the rear surface of the heat dissipation housing main body 110, but multiple heat dissipation apparatuses may be disposed to be spaced apart from each other at a predetermined interval left and right.

However, although not illustrated in the drawings, the multiple heat dissipation apparatuses 200 should not be essentially disposed vertically, and may be upward slantly disposed toward the left and right ends of a middle portion of the rear surface of the heat dissipation housing main body 110.

As described above, the reason why the multiple heat dissipation apparatuses 200 for an electronic device according to an embodiment of the present disclosure are disposed vertically and upward slantly is to allow an ascending air current of discharge heat, which is generated through the exchange of heat with external air, to smoothly exit to the outside between the heat dissipation apparatuses 200 that are adjacent to each other and along the slanted heat dissipation apparatus 200 in the state in which air current resistance has been minimized.

Meanwhile, in addition to the heat dissipation apparatus 200 for an electronic device according to an embodiment of the present disclosure, a fixed heat dissipation pin 200F may be disposed on the rear surface of the heat dissipation housing main body 110. The fixed heat dissipation pin 200F is separately manufactured and then detachably coupled to the rear surface of the heat dissipation housing main body 110 like the heat dissipation apparatus 200 for an electronic device according to an embodiment of the present disclosure, but may be defined as a component into which a refrigerant is not filled and that discharges heat of the heating elements by only the thermal conductivity of a metal material thereof itself.

In this case, as referred to in FIGS. 1 and 2, the fixed heat dissipation pin 200F may be disposed below a rear part of the heat dissipation housing main body 110, which is not occupied by the heat dissipation apparatus 200 for an electronic device according to an embodiment of the present disclosure.

Furthermore, as referred to in FIGS. 1 and 2, a press-fit part 150 provided for the press-fit installation of the multiple heat dissipation apparatuses 200 according to an embodiment of the present disclosure may be formed on the rear surface of the heat dissipation housing main body 110.

The press-fit part 150 may be provided approximately in a slot form so that a part of the front end of the heat dissipation apparatuses 200 according to an embodiment of the present disclosure is inserted into the press-fit part.

In this case, the meaning that the press-fit part 150 is provided in the slot form is a concept, including that a pair of slot ribs (a reference numeral not assigned) protrudes backward from the rear surface of the heat dissipation housing main body 110 and an insertion space, such as a groove into which a front end (or a part of the front end) of the heat dissipation apparatus 200 for an electronic device according to an embodiment of the present disclosure is inserted, is provided between the pair of slot ribs.

In this case, it is preferred that although not illustrated in the drawings, the front end (or a part of the front end) of the heat dissipation apparatus is press-fit into the press-fit part 150 after thermal epoxy treatment in order to improve heat transfer efficiency.

In this case, the press-fit part 150 may be disposed to pass through at least one of heat dissipation shape-matching surfaces (not illustrated) that are formed to protrude while being backward depressed so that the heat dissipation surfaces of the heating elements are accommodated in an inside corresponding to the rear surface of the heat dissipation housing main body 110.

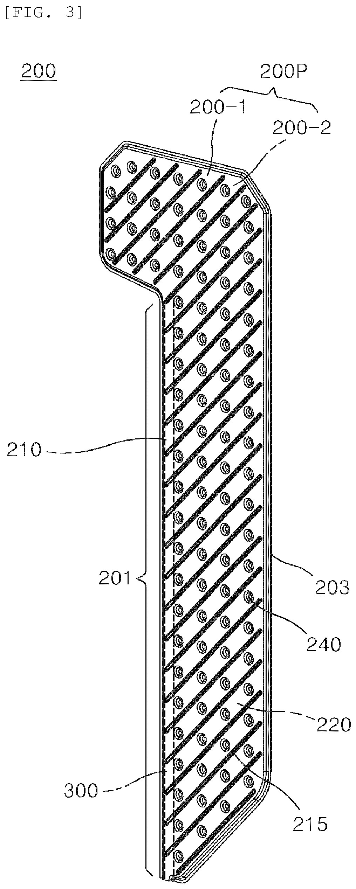

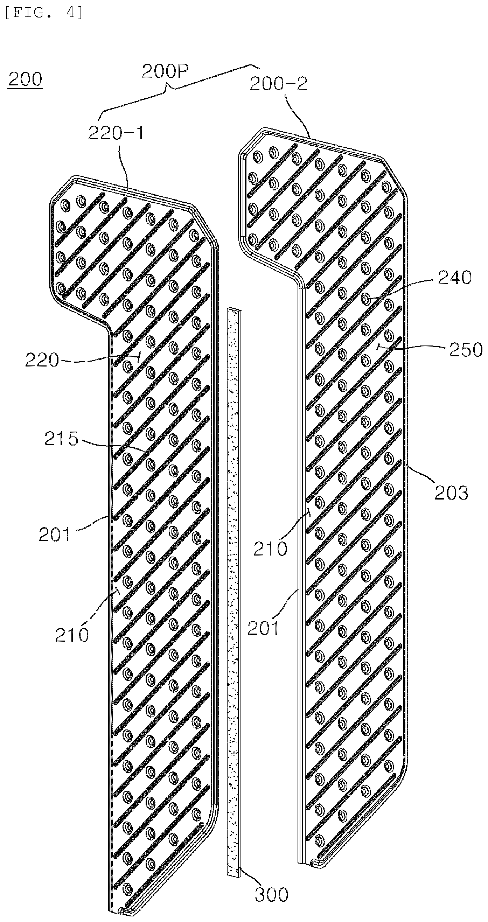

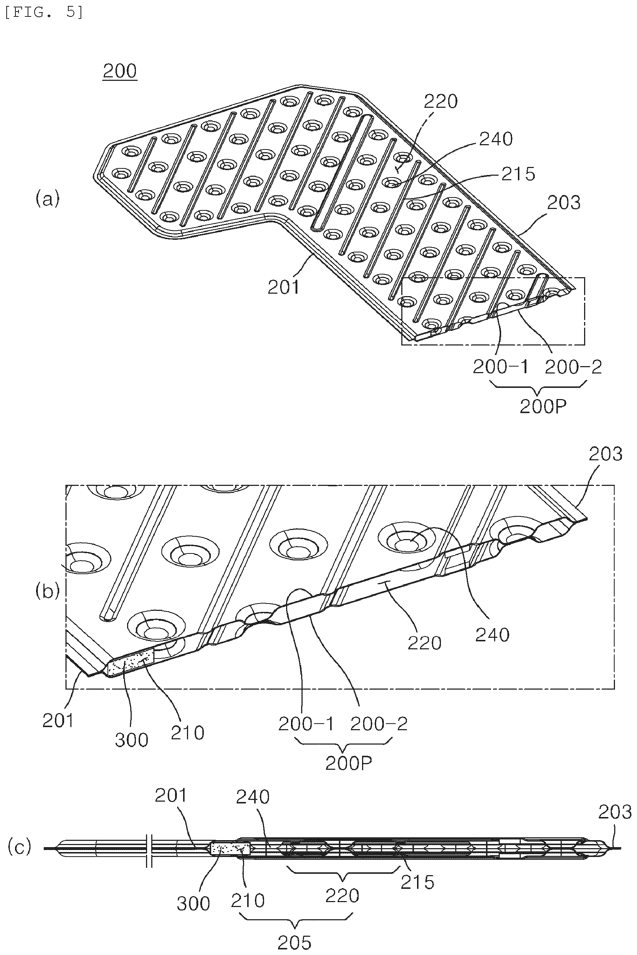

FIG. 3 is a perspective view illustrating the heat dissipation apparatus for an electronic device according to an embodiment of the present disclosure. FIG. 4 is an exploded perspective view of FIG. 3. FIG. 5 is an incision perspective view (a) of FIG. 3, a partially enlarged view (b) thereof, and a cross-sectional view (c) of a corresponding portion.

As reference in FIGS. 3 to 5, the heat dissipation apparatus 200 for an electronic device according to an embodiment of the present disclosure may include a heat conduction panel body 200P having a refrigerant flow space 205 that provides a space in which a liquefied refrigerant and a gaseous refrigerant are circulated so that the refrigerant is filled into the space and discharges heat while the state of the refrigerant is changed within the closed space.

In this case, the heat conduction panel body 200P may be defined as a component that has been processed and formed to have the refrigerant flow space 205 therein by a bending or bonding method after a panel member of a single metal material is subjected to press processing.

Meanwhile, the refrigerant flow space 205 may include a first refrigerant flow path 210 that forms an evaporation area in which a liquefied refrigerant in the liquid state, which is included in a filled refrigerant, is collected by at least any one of gravity or a capillary force and evaporated while the state of the liquefied refrigerant is changed into the state of a gaseous refrigerant in the gas state by heat that is transferred from the heating elements.

The first refrigerant flow path 210 is a front end of the heat conduction panel body 200P that is formed through the bending or bonding process in a width direction thereof, and may include a space that occupies a part of the refrigerant filling and flow space into which a liquefied refrigerant included in a refrigerant is filled by a separated distance according to the material thickness of the heat conduction panel body 200P provided as the panel member of a metal material with respect to the press-fit part 150 equipped with the heating elements.

Specifically, the "separated distance according to the material thickness" means a distance at which the first refrigerant flow path 210 and the heating elements or the press-fit part 150 equipped with the heating elements are spaced apart from each other. In this case, the definition of the first refrigerant flow path 210 will have greater significance as the evaporation area, that is, an end part to which heat from the heating elements, that is, a heat dissipation target, to the heat conduction panel body 200P is supplied in the width direction thereof, in that the first refrigerant flow path is not a space in which only a form of a liquefied refrigerant is simply collected.

Meanwhile, the refrigerant flow space 205 may further include multiple second refrigerant flow paths 220 that induce a flow of a liquefied refrigerant toward the first refrigerant flow path 210.

In this case, if the portion including the first refrigerant flow path 210 is described as the evaporation area as described above, the remaining portions except the evaporation area may be defined as a condensation area. The second refrigerant flow path 220 may be provided in the condensation area, that is, the remaining portions except the evaporation area.

When a gaseous refrigerant in the gas state within the condensation area is aggregated and condensed as a liquefied refrigerant in the liquid state through the transfer of heat with outside air, the volume of the liquefied refrigerant is gradually increased at the position of the liquefied refrigerant within the refrigerant flow space 205 at which the liquefied refrigerant is condensed. At this time, when the liquefied refrigerant flows down in the direction of gravity, the multiple second refrigerant flow paths 220 may function to provide a flow path so that a uniform amount of the liquefied refrigerant is provided toward the first refrigerant flow path 210 that is lengthways disposed up and down vertically.

In particular, as will be described later, the second refrigerant flow path 220 may be defined between multiple slant guides 215. When the liquefied refrigerant condensed in the condensation area flows down toward the first refrigerant flow path 210, the distribution flow of the liquefied refrigerant toward the second refrigerant flow path 220 adjacent to the second refrigerant flow path 220, that is, its own flow path, can be suppressed by surface tension thereof.

That is, the multiple slant guides 215 each have a space narrower than the thickness of the second refrigerant flow path 220. Accordingly, a flow of the refrigerant toward an adjacent second refrigerant flow path 220 is suppressed due to surface tension acts on the refrigerant in a process of the refrigerant being condensed. As a result, a flow of the refrigerant toward the first refrigerant flow path 210 is uniformly guided along its own flow path.

Meanwhile, as referred to in FIGS. 3 to 5, the heat conduction panel body 200P may include one-side heat conduction panel 200-1 that forms one side of the refrigerant flow space and the other-side heat conduction panel 200-2 that forms the other side of the refrigerant flow space.

In this case, the heat dissipation apparatus 200 for an electronic device according to an embodiment of the present disclosure may further include multiple strength reinforcement parts 240 that are formed on at least one side of the one-side heat conduction panel 200-1 and the other-side heat conduction panel 200-2, that are formed to protrude from an inner surface of the one-side heat conduction panel 200-1 and the other-side heat conduction panel 200-2 toward the refrigerant flow space in a predetermined length, and that are formed to face each other.

In general, the multiple strength reinforcement parts 240 are formed on at least any one of the one-side heat conduction panel 200-1 and the other-side heat conduction panel 200-2 each having a plan shape, and may function to reinforce strength in order to prevent a sagging or pressing phenomenon attributable to external pressure.

In this case, the front end surface of each of the multiple strength reinforcement parts 240 may be formed to more protrude toward at least the refrigerant flow space than the front end of the multiple slant guides 215. In this case, it is preferred that the front end surfaces of the multiple strength reinforcement parts 240, which protrude toward the refrigerant flow space, protrude in a size at least to the extent that portions of the one-side heat conduction panel and the other-side heat conduction panel, which come into surface contact with each other, can be bonded when the one-side heat conduction panel 200-1 and the other-side heat conduction panel 200-2 are bonded.

However, the multiple strength reinforcement parts 240 do not essentially need to come into surface contact with each other within the refrigerant flow space, and may be spaced apart from each other within the refrigerant flow space like the slant guides 215. The reason for this is that the forming itself of the multiple strength reinforcement parts 240 has a function that reinforces strength of the one-side heat conduction panel 200-1 and the other-side heat conduction panel 200-2.

Furthermore, the multiple strength reinforcement parts 240 are formed in the one-side heat conduction panel 200-1 and the other-side heat conduction panel 200-2 in a way to be symmetrical to each other on the basis of an arbitrary reference line, but may be formed only in the multiple slant guides 215.

In this case, the multiple strength reinforcement parts 240 are formed in a surface where the one-side heat conduction panel 200-1 and the other-side heat conduction panel 200-2 of the heat conduction panel body 200P face each other, but the front end surfaces thereof may be disposed to face each other within the refrigerant flow space 205. Furthermore, the surface that face each other and a surface that neighbors the surface in the multiple strength reinforcement parts 240 that are disposed to face each other may be combined by a laser welding method.

In particular, it is preferred that the multiple strength reinforcement parts 240 are formed above the multiple slant guides 215 that define the second refrigerant flow path 220 that mainly plays a role as the flow path of the gaseous refrigerant so that a condensing surface area in which a gaseous refrigerant that is included in a refrigerant and that has a state changed into the gas state is brought into contact and aggregated while flowing is increased.

In this case, the liquefied refrigerant on the first refrigerant flow path 210 that belongs to the refrigerant flow space 205 and that is provided proximately to the heating elements reaches the boiling point of the refrigerant by being supplied with heat from the heating elements, the state of the liquefied refrigerant is changed into the state of the gaseous refrigerant.

However, in the case of the refrigerant that is filled into the refrigerant flow space 205 of the heat conduction panel body 200P, a gas refrigerant space (volume) should not be fully filled with only the liquefied refrigerant in order to secure for a change from the state of the liquefied refrigerant to the state of the gaseous refrigerant, and the refrigerant flow space 205 is filled with very few of the liquefied refrigerant. Accordingly, if the first refrigerant flow path 210 is disposed up and down in the direction of gravity, an upper side of the first refrigerant flow path 210 inevitably becomes an empty space not including the liquefied refrigerant. In this case, it may be difficult to secure generally uniform heat dissipation performance because the first refrigerant flow path 210 corresponding to the empty space not including the liquefied refrigerant and the first refrigerant flow path 210 occupied by the liquefied refrigerant have different amounts of evaporation.

In order to solve such a problem, as referred to in FIGS. 3 to 5, the heat dissipation apparatus 200 for an electronic device according to an embodiment of the present disclosure may further include the absorber 300 that absorbs a refrigerant in the liquid state, which is included in a refrigerant derived through the second refrigerant flow path 220, and then uniformly distributes the refrigerant in the liquid state to the first refrigerant flow path 210.

In this case, the absorber 300 is a concept including a wick member having a wick structure, which is provided within a common vapor chamber, but is not limited thereto. The absorber may be a concept including both a material or component capable of maximizing heat dissipation performance by raising limitations in the heat conduction material of the existing common heat dissipation pin, by generally collecting and distributing a liquefied refrigerant up and down on the first refrigerant flow path 210 that is vertically disposed with respect to the direction of gravity.

Meanwhile, it is preferred that the absorber 300 is installed within the first refrigerant flow path 210, that is, a side close to the inside of the press-fit end 201 as much as possible because the state of a liquefied refrigerant can be actively changed into the state of a gaseous refrigerant more easily by heat that is transferred from the heating elements as the liquefied refrigerant becomes closer to the press-fit end 201.

However, the absorber 300 should not be essentially internally installed close to only the press-fit end 201, and may be installed so that a refrigerant is uniformly distributed over the entire evaporation area in which the refrigerant can be evaporated.

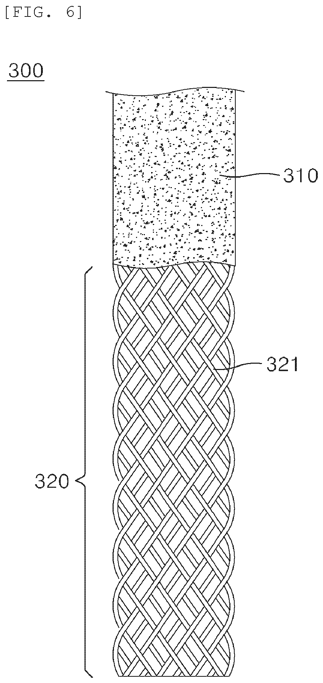

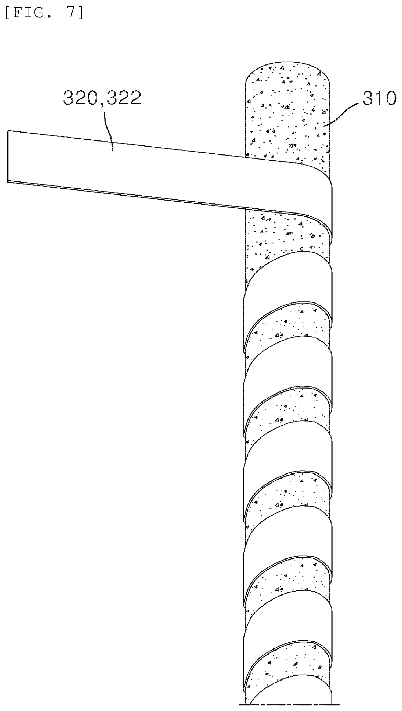

FIGS. 6 and 7 are perspective views illustrating various embodiments of the absorber, among the components of FIG. 5.

In the heat dissipation apparatus 200 for an electronic device according to an embodiment of the present disclosure, the absorber 300 is disposed in the refrigerant flow space 205 of the heat conduction panel body 200P, and may function to distribute a liquefied refrigerant in the direction of gravity or at least in a direction opposite to the direction of gravity while absorbing and maintaining the liquefied refrigerant included in a refrigerant.

More specifically, as referred to in FIGS. 6 and 7, the absorber 300 may include an absorption body part 310 that has a predetermined absorption rate for a liquefied refrigerant and that is made of a material having a shape deformed by an external force including predetermined gravity or more and a frame retention part 320 that is combined with the absorption body part 310 and that prevents the deformation of the shape of the absorption body part 310 attributable to the external force.

In this case, the absorption body part 310 may be made of at least one of non-woven fabric, cotton, and sponge, which forms multiple pores (a kind of wick structure). The absorption body part 310 made of non-woven fabric, cotton, or sponge may be lengthily disposed in the direction of gravity due to the nature of its material. However, if the multiple pores contain liquids, an appearance (shape) of the absorption body part may be modified, such as being sagged in the direction of gravity due to the weight of the liquid.

The frame retention part 320 functions to prevent the deformation of the shape of the absorption body part 310, such as the sagging phenomenon of the absorption body part. To this end, the frame retention part 320 may have a tube shape in which the frame retention part forms a hollow (a reference numeral not assigned) in which the absorption body part 310 is disposed.

Preferably, a metal material having predetermined thermal conductivity or more may be preferred as being adopted as the frame retention part 320 because the frame retention part is a component that needs to transfer heat transferred from external heating elements to the internal absorption body part 310. For example, the metal material of the frame retention part 320 may be a copper (Cu) material.

Furthermore, the frame retention part 320 may be braided in a tube shape (refer to reference numeral "321") as referred to in FIG. 6, or may be provided to be wound in a spiral shape (refer to reference numeral "322") as referred to in FIG. 7.

More specifically, referring to FIG. 6, the frame retention part 321 may have a metal (copper (Cu)) wire of a metal material to be provided to be braided in a tube shape so that a liquefied refrigerant derived toward the first refrigerant flow path 210 through the multiple second refrigerant flow paths 220 permeate the internal absorption body part 310.

In this case, the frame retention part 321 may be braided to have a gap through which at least a liquefied refrigerant included in a refrigerant is transferred from the outside to the internal absorption body part 310 by its surface tension. In this case, a gaseous refrigerant the state of which has been changed from the liquefied refrigerant can be easily distributed to the outside through the braided gap by the absorption body part 310.

Furthermore, referring to FIG. 7, the frame retention part 322 may have a metal (copper (Cu)) panel (or wire) to be provided to be wound on the outside of the absorption body part 310 in a spiral shape.

In this case, it is preferred that the metal panel (or the metal wire) has a shape retention force at least to the extent that the downward sagging of the absorption body part 310 by gravity is prevented although a sufficient liquefied refrigerant is included in the absorption body part.

Meanwhile, as referred to in FIG. 6, the frame retention part 321 of the absorber 300 is formed in a cylindrical shape. The absorption body part 310 may be formed in a cylindrical shape so that the absorption body part is inserted into the frame retention part 321 formed in the cylindrical shape.

As described above, in the heat dissipation apparatus 200 for an electronic device according to an embodiment of the present disclosure, the absorber 300 has the absorption body part 310 and the frame retention part 320 separately manufactured and combined, but does not need to essentially additionally include the frame retention part 320. The provision of the absorption body part 310 itself may be sufficient if the shape of the absorption body part 310 is not deformed, such as sagging, by the shape retention force of the absorption body part although a liquefied refrigerant is included in the absorption body part 310.

The absorber 300 according to the embodiments includes the absorption body part 310 made of any one material, among non-woven fabric, cotton, and sponge, and the frame retention part 320 that is braided on the absorption body part in the tube shape or wound on the absorption body part in the spiral shape as the metal (copper (Cu)) wire material. Accordingly, the state of a liquefied refrigerant having a uniform amount can be changed on the first refrigerant flow path 210 because the liquefied refrigerant prevents the absorption body part 310 from being downward sagged regardless of the amount of the liquefied refrigerant contained in the absorption body part 310.

Meanwhile, the heat dissipation apparatus 200 for an electronic device according to an embodiment of the present disclosure may further include multiple absorber fixing guides (not illustrated) that are shaped simultaneously with the first refrigerant flow path to the second refrigerant flow paths 210 to 220 and the multiple slant guides 215 or the multiple strength reinforcement parts 240 when the heat conduction panel body 200P is shaped by a press process, although not illustrated in the drawings.

When the absorber 300 adopted as woven fabric absorbs a liquefied refrigerant, the absorber have a concern of being sagged in the direction of gravity. The multiple absorber fixing guides are formed to protrude toward the refrigerant flow space in order to prevent such sagging, and may function to stably fix the absorber 300 while pressing the absorber when the one-side heat conduction panel 200-1 and the other-side heat conduction panel 200-2 are bonded.

Furthermore, the multiple absorber fixing guides may also function to secure a space in which a refrigerant in the gas state (gaseous refrigerant), which has been evaporated within the first refrigerant flow path 210, can flow by pressing an outside portion of the absorption body part 310 or the frame retention part 320 provided as a flexible material.

As described above, the absorber 300 is installed within the first refrigerant flow path 210. A liquefied refrigerant and a gaseous refrigerant may be circulated within the absorber so that after a liquefied refrigerant that has been liquefied from a heat dissipation plate part 203 is moved to a portion close to the heating elements by the absorption force (or capillary force) of the absorber 300, a gaseous refrigerant the state of which has been changed by heat transferred from the heating elements is repeatedly moved toward the heat dissipation plate part 203 again.

A gaseous refrigerant that has moved to the heat dissipation plate part 203 is generally uniformly distributed and aggregated while discharging heat. An aggregated liquefied refrigerant can be easily moved to the first refrigerant flow path 210, that is, a self-weight direction, along the second refrigerant flow path 220 having a relatively larger size than each of the multiple slant guides 215 in a thickness direction thereof again.

Heat generated from the heating elements is first transferred to the first refrigerant flow path 210 in which the absorber 300 has been installed. Most of a refrigerant stored in the first refrigerant flow path 210 equipped with the absorber 300 is in the liquid state, and the state of the refrigerant is changed into the gaseous state by the heat transferred from the heating elements. Thereafter, the gaseous refrigerant discharges heat while flowing into the entire heat dissipation plate part 203 of the heat conduction panel body 200P.

The heat dissipation apparatus 200 for an electronic device according to an embodiment of the present disclosure has been described above in detail with reference to the accompanying drawings. However, an embodiment of the present disclosure is not essentially limited to the aforementioned embodiment, and may include various modifications and implementations within an equivalent range thereof by a person having ordinary knowledge in the art to which the present disclosure pertains. Accordingly, the true range of a right of the present disclosure will be said to be defined by the appended claims.

### [Industrial Applicability]

The present disclosure provides the heat dissipation apparatus for an electronic device, including the absorber capable of forming a dispersion force greater than surface tension of liquids in a direction opposite to the direction of gravity through the liquid absorption rate of a material itself and maintaining its shape even in the state in which the absorber has absorbed a liquefied refrigerant.

## Claims

1. A heat dissipation apparatus for an electronic device, comprising:
a heat conduction panel body in which a refrigerant flow space where a liquefied refrigerant and a gaseous refrigerant are circulated while a state of a refrigerant filled therein is changed has been formed; and
an absorber disposed in the refrigerant flow space of the heat conduction panel body and configured to distribute a liquefied refrigerant included in the refrigerant in a direction of gravity or at least in a direction opposite to the direction of gravity while absorbing and retaining the liquefied refrigerant,
wherein the absorber maintains an absorption rate for the liquefied refrigerant by a material itself, and a shape of the absorber is prevented from being deformed in the direction of gravity.

2. The heat dissipation apparatus of claim 1, wherein the absorber comprises:
an absorption body part having an absorption rate for the liquefied refrigerant and having a shape deformed by an external force having predetermined gravity or more; and
a frame retention part combined with the absorption body part and configured to prevent the shape of the absorption body part from being deformed by the external force.

3. The heat dissipation apparatus of claim 2, wherein the absorption body part is made of at least one of non-woven fabric, cotton, and sponge.

4. The heat dissipation apparatus of claim 2, wherein the frame retention part is formed in a tube shape in which the frame retention part forms a hollow having the absorption body part disposed therein as a metal material.

5. The heat dissipation apparatus of claim 4, wherein the frame retention part has a metal wire braided in the tube shape.

6. The heat dissipation apparatus of claim 5, wherein the frame retention part is braided to have a gap through which at least a liquefied refrigerant included in the refrigerant is transferred from an outside to the internal absorption body part by surface tension of the liquefied refrigerant.

7. The heat dissipation apparatus of claim 4, wherein a material having predetermined thermal conductivity or more is adopted as the metal material of the frame retention part.

8. The heat dissipation apparatus of claim 7, wherein the metal material of the frame retention part comprises copper.

9. The heat dissipation apparatus of claim 2, wherein:
the frame retention part is formed in a cylindrical shape, and
the absorption body part is formed in a cylindrical shape so that the absorption body part is inserted into the frame retention part formed in the cylindrical shape.

10. The heat dissipation apparatus of claim 1, wherein:
the heat conduction panel body is formed of a metal panel member having predetermined thermal conductivity or more, and comprises one-side heat conduction panel that forms one side of the refrigerant flow space and the other-side heat conduction panel that forms the other side of the refrigerant flow space, and
the absorber is installed close to an end that belongs to the refrigerant flow space between the one-side heat conduction panel and the other-side heat conduction panel and that is adjacent to an external heating element on one side thereof.

11. The heat dissipation apparatus of claim 10, wherein the refrigerant flow space comprises:
a first refrigerant flow path that forms the end on the one side at which the absorber is installed; and
a second refrigerant flow path slantly formed in the direction of gravity with respect to the first refrigerant flow path and defined by slant guides formed in the one-side heat conduction panel and the other-side heat conduction panel so that a thickness of the refrigerant flow space is reduced,
wherein the absorber is installed in the first refrigerant flow path.

12. The heat dissipation apparatus of claim 11, wherein when the first refrigerant flow path in which the absorber is installed is installed to receive heat of the heating element, at least one end and the other end of the absorber are disposed to be spaced apart from each other at a predetermined interval in the direction of gravity.
